Europäisches Patentamt

European Patent Office

Office européen des brevets

(19)

(11) Veröffentlichungsnummer: **0 185 787**
**B1**

(12) **EUROPÄISCHE PATENTSCHRIFT**

(45) Veröffentlichungstag der Patentschrift:
**10.08.88**

(21) Anmeldenummer: **84116019.5**

(22) Anmeldetag: **21.12.84**

(51) Int. Cl.⁴: **H 01 L 23/28** //
**H01L23/30**

(54) **Plastikumhülltes Halbleiterbauelement.**

(43) Veröffentlichungstag der Anmeldung:
**02.07.86 Patentblatt 86/27**

(45) Bekanntmachung des Hinweises auf die Patenterteilung:
**10.08.88 Patentblatt 88/32**

(84) Benannte Vertragsstaaten:
**DE FR NL**

(56) Entgegenhaltungen:
DE-A-3 021 206
DE-A-3 116 406
US-A-4 001 872

PATENTS ABSTRACTS OF JAPAN, Band 7, Nr. 62 (E-164) 1207 , 15. März 1983; & JP - A - 57 210 646 (SUWA SEIKOSHA K.K.) 24.12.1982
PATENTS ABSTRACTS OF JAPAN, Band 5, Nr. 198 (E-87) 870 , 16. Dezember 1981; & JP - A - 56 120 167 (SANYO DENKI K.K.) 21.09.1981
IBM TECHNICAL DISCLOSURE BULLETIN, Band 26, Nr. 8, Januar 1984, Seiten 4409-4410, New York, US; D.L. BERGERON: "Passivation structure"

(73) Patentinhaber: **Deutsche ITT Industries GmbH, Hans- Bunte- Strasse 19 Postfach 840, D-7800 Freiburg (DE)**

(72) Erfinder: **Vogt, Helga, Mehlwaage 8, D-7800 Freiburg i.Br. (DE)**

(74) Vertreter: **Morstadt, Volker, Dipl.- Ing., c/o Deutsche ITT Industries GmbH Patent/Lizenzabteilung Postfach 840 Hans- Bunte- Strasse 19, D-7800 Freiburg/Brsg. (DE)**

EP 0 185 787 B1

### Beschreibung

Die Erfindung betrifft ein plastikumhülltes Halbleiterbauelement mit einem Halbleiterkörper, der mindestens auf einer Seite mit Metallkontakten und/oder Leiterbahnen versehen ist, wobei eine Siliciumnitridschutzschicht die gesamte Oberfläche des Halbleiterkörpers einschließlich der Elektroden und Leitbahnenmuster bedeckt, vgl. den Oberbegriff des Anspruchs 1.

Halbleiterbauelemente werden bekanntlich in der Weise hergestellt, daß man eine Scheibe aus Halbleitermaterial mit Zonen verschiedenen Leitungstyps versieht, die durch Bahnen aus Leitermaterial, wie z. B. Aluminium, verbunden werden. Die Halbleiterscheiben und -systeme sind sehr empfindlich und können leicht beschädigt werden. Bei der weiteren Verarbeitung kann es zu Verunreinigungen aus der Umgebung bzw. zu Beschädigung der schmalen und dicht beabstandeten Leiterbahnen kommen. Als Folge davon treten Veränderungen in den elektrischen Eigenschaften der Halbleiterbauelemente auf. Um dies zu vermeiden, werden deshalb Schutzschichten auf die Halbleiterkörper aufgebracht, die deren Oberfläche sowie die darauf angeordneten Leiterbahnen und Elektroden schützen. Als Schutzschichten sind Isoliermaterialien, welche auch getternde Eigenschaften besitzen, beispielsweise aus der Zeitschrift "IBM Journal" (September 1964), Seiten 376 bis 384 und (April 1964), Seiten 102 bis 114 allgemein bekannt. Aufgrund seiner Eigenschaften hat sich Siliciumnitrid als besonders geeignetes Material für die Herstellung von Schutzschichten auf Halbleiterkörpern erwiesen. Es schützt die bedeckten Oberflächen sowohl gegen mechanische Beschädigungen (Kratzer) als auch gegen atmosphärische Einflüsse (Fremdionenverunreinigung).

Das eingangs bereits beschriebene und aus der Offenlegung DE-1 614 374 bekannte Halbleiterbauelement weist jedoch auch Nachteile auf. Um verkaufsfähige Halbleiterbauelemente zu erhalten werden die Halbleiterkörper bekanntlich nach dem Anbringen der elektrischen Verbindungen zu ihrem Schutz und zur besseren Handhabung des Halbleiterbauelements in einem Gehäuse untergebracht. Dieses kann ein Glas-, Keramik-, Metall- oder Plastikgehäuse sein. Das Einbringen in ein Plastikgehäuse erfolgt durch Umpressen oder Umspritzen. Dabei treten zwangsläufig hohe Scherkräfte auf, die in dem Gehäuse zum Abscheren der aus z. B. Aluminium bestehenden Leitbahnen führen können. Der Grund hierfür liegt darin, daß die Dicke der Siliciumnitridschutzschicht nicht ausreicht, um die freien Flächen zwischen den Aluminiumleitbahnen soweit aufzufüllen, daß kein seitlicher Druck auf sie beim Verkapselungsvorgang ausgeübt werden kann. Außerdem folgt das Siliciumnitrid bei der Abscheidung genau der vorgegebenen Struktur, so daß scharfe Kanten auftreten, was die Möglichkeit der seitlichen Druckausübung begünstigt.

Ferner muß die Stärke der Siliciumnitridschicht so bemessen sein, daß keine Spannungen und damit Rißbildungen auftreten, was zum Absplittern bzw. Zerbrechen der Siliciumnitridschicht führen würde. Dies bedeutet aber eine Stärke der Siliciumnitridschicht, die geringer ist als die Höhe der Aluminiumleitbahnen und somit wiederum einen nicht ausreichenden Schutz gegen Seitendruck.

Hier will die Erfindung Abhilfe schaffen. Die Erfindung, wie sie in den Ansprüchen gekennzeichnet ist, löst die Aufgabe, ein Halbleiterbauelement anzugeben, dessen Leitbahnen und Kontakte gegen Abscheren geschützt sind.

Die durch die Erfindung erreichten Vorteile liegen einmal in der Lösung der Aufgabe selbst, nämlich in der Bereitstellung eines Halbleiterbauelements, dessen Leitbahnen gegen das Abscheren geschützt sind, zum anderen in der damit verbundenen Qualitätsverbesserung und Ausbeutenerhöhung bei der Fertigung der Halbleiterbauelemente.

Im folgenden wird die Erfindung anhand der Figuren der Zeichnung näher erläutert.

Fig. 1 zeigt einen Ausschnitt aus einem Halbleiterkörper eines Halbleiterbauelements nach dem Stand der Technik,

Fig. 2 und 3 zeigen Teilausschnitte von Ausführungsbeispielen der Erfindung.

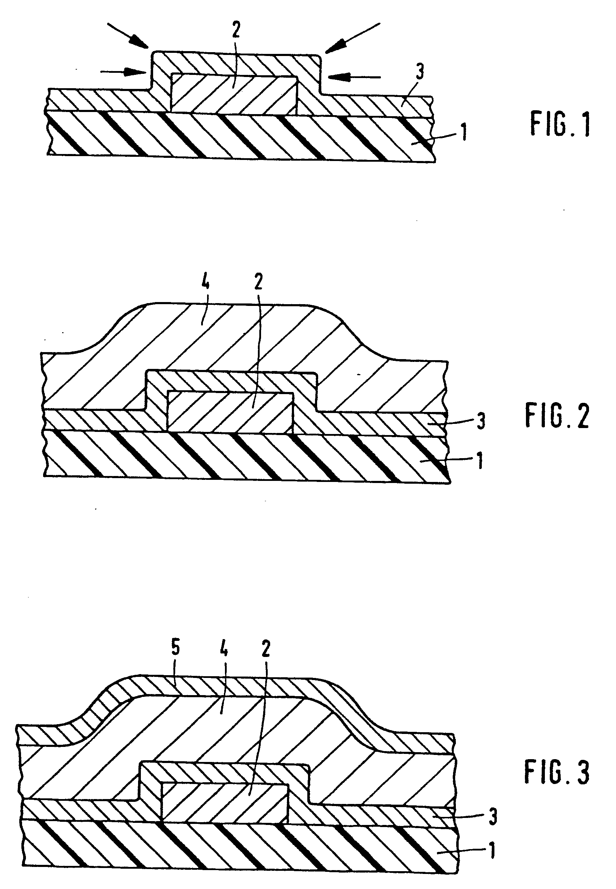

Die Fig. 1 der Zeichnung veranschaulicht den Ausschnitt des Halbleiterkörpers eines Halbleiterbauelements nach dem Stand der Technik, das den Halbleiterkörper 1 enthält, in dem die nichtgezeigten unterschiedlichen Zonen ausgebildet sind. Auf der einen seiner Oberflächen ist die Leitbahn 2 aus z. B. Aluminium angeordnet, die wie die restliche freie Oberfläche des Halbleiterkörpers von der Sillciumnitridschicht 3 abgedeckt ist, deren Stärke zwischen 0,2 µm und 0,8 µm, vorzugsweise bei 0,4 µm liegt. Die Angriffspunkte, scharfe Kanten und Seitenflächen, sind in Fig. 1 durch Pfeile markiert.

Das Ausführungsbeispiel der Erfindung nach Fig. 2 unterscheidet sich von Fig. 1 durch die die Siliciumnitridschicht 3 überziehende Siliciumdioxidschicht 4, deren Stärke zwischen 0,8 und 2,0 µm, vorzugsweise zwishen 1,0 bis 1,2 µm beträgt. Sie kann, wenn erforderlich, selbst wiederum von der Siliciumnitridschicht 5 in der Stärke von z. B. 0,4 µm abgedeckt sein, wie Fig. 3 zeigt.

Zur Herstellung der Anordnungen nach Fig. 2 und 3 wird ausgehend vom Halbleiterkörper 1 in bekannter Weise in diesem nach den herkömmlichen Verfahren die in Fig. 1 gezeigte Struktur erzeugt, wobei die Siliciumnitridschicht 3 durch Abscheidung aus der Dampfphase unter Verwendung von Silan und Ammoniak in einem Plasmareaktor erfolgt. Unter Verwendung des gleichen Reaktors und Ersatz des Ammoniaks durch Sauerstoff wird eine z. B. 1,0 bis 1,2 μm starke Siliciumdioxidschicht 4 auf der Siliciumnitridschicht 3 abgeschieden. (Fig. 2). Wenn erforderlich, kann nach dem oben genannten Verfahren auf der Siliciumdioxidschicht 4 die weitere Siliciumnitridschicht 5 abgeschieden werden.

Das abgeschiedene Siliciumdioxid kann rein sein, es besteht jedoch auch die Möglichkeit, dotiertes Siliciumdioxid als Schutzschicht einzusetzen.

**Patentansprüche**

1. Plastikumhülltes Halbleiterbauelement mit einem Halbleiterkörper (1), der mindestens auf einer Seite mit Elektroden und Leitbahnen versehen ist, wobei die gesamte Oberfläche des Halbleiterkörpers einschließlich der Elektroden und Leitbahnen von einer Siliciumnitridschutzschicht (3) bedeckt ist, dadurch gekennzeichnet, daß die Siliciumnitridschutzschicht (3) mit einer Siliciumdioxidschutzschicht (4) überzogen ist.

2. Plastikumhülltes Halbleiterbauelement nach Anspruch 1 dadurch gekennzeichnet, das die Siliciumdioxidschicht (4) mit einer weiteren Siliciumnitridschicht (5) überzogen ist.

3. Plastikumhülltes Halbleiterbauelement nach den Ansprüchen 1 oder 2, dadurch gekennzeichnet, daß die Siliciumnitridschutzschicht(en) (3, 5) eine Stärke von 0,2 bis 0,8 μm und die Siliciumdioxidschicht eine Stärke von 0,8 bis 2,0 μm haben.

**Claims**

1. Plastics-encapsulated semiconductor device comprising a semiconductor body (1) which, at least on one side, is provided with electrodes and conducting leads, with the entire surface of the semiconductor body, Including the electrodes and conducting leads, being covered by a coating (3) of silicon nitride, characterized in that the coating (3) of silicon nitride is covered with a coating (4) of silicon dioxide.

2. A plastics-encapsulated semiconductor device as claimed in claim 1, characterized in that the coating (4) of silicon dioxide is covered with a further coating (5) of silicon nitride.

3. A plastics-encapsulated semiconductor device as claimed in claims 1 or 2, characterized in that the one or more coatings (3, 5) of silicon nitride have a thickness ranging between 0.2 and 0.8 μm, and that the coating (4) of silicon dioxide has a thickness ranging between 0.8 and 2.0 μm.

**Revendications**

1. Composant à semi-conducteurs encapsulé dans une matière plastique et comprenant un corps semi-conducteur (1), qui comporte, au moins sur une face, des électrodes et des voies conductrices, l'ensemble de la surface du corps semi-conducteur ainsi que les électrodes et les voies conductrices étant recouverts par une couche de protection en nitrure de silicium (3), caractérisé en ce que la couche de protection en nitrure de silicium (3) est recouverte par une couche de protection en bioxyde de silicium (4).

2. Composant à semi-conducteurs encapsulé dans une matière plastique selon la revendication 1, caractérisé en ce que la couche de bioxyde de silicium (4) est recouverte par une autre couche de nitrure de silicium (5).

3. Composant à semi-conducteurs encapsulé dans une matière plastique selon les revendications 1 ou 2, caractérisé en ce que la ou les couches de protection en nitrure de silicium (3, 5) possèdent une épaisseur de 0,2 à 0,8 μm et que la couche de bioxyde de silicium possède une épaisseur de 0,8 à 2,0 μm.

FIG.1

FIG.2

FIG.3